# EUROPÄISCHE PATENTSCHRIFT

(11) **EP 1 536 563 B1**
(45) Veröffentlichungstag und Bekanntmachung des Hinweises auf die Patenterteilung: **17.01.2007**
(21) Anmeldenummer: 03027507.7
(22) Anmeldetag: 28.11.2003
(51) Int. Cl.: H03K 17/082

(54) **Lastschaltvorrichtung und Verfahren zur Diagnose eines Laststromkreises mit einer Lastschaltvorrichtung**
Load switching circuit and diagnostic therefor
Circuit de commutation de charge et procédé diagnostique associé

(43) Veröffentlichungstag der Anmeldung: 01.06.2005
(73) Patentinhaber: Delphi Technologies, Inc., Troy, MI 48007 (US)
(72) Erfinder: Giesen, Marko, 51588 Nümbrecht (DE); Trommer, Frank, O., 51588 Nümbrecht (DE); Lehmann, Klaus, 53797 Lohmar (DE); Stadler, Peter, 57482 Wenden (DE); Schulte, Thomas, 58540 Meinerzhagen Windebruch (DE)
(74) Vertreter: Manitz, Finsterwald & Partner GbR

(56) Entgegenhaltungen:
- EP-A1- 1 143 618
- US-A1- 2002 176 215

## Beschreibung

Die vorliegende Erfindung betrifft eine Lastschaltvorrichtung zum Öffnen und Schließen eines Laststromkreises, der eine zu schaltende elektrische Last und eine Versorgungsstrom- oder -spannungsquelle umfasst, in Abhängigkeit von einem Schaltsignal, mit einer Schalteinrichtung mit einem Schaltsignaleingang, einem Versorgungsanschluss und einem Lastanschluss, mittels derer in Abhängigkeit von dem Schaltsignal an dem Schaltsignaleingang der Versorgungsanschluss elektrisch mit dem Lastanschluss verbindbar oder von diesem trennbar ist, einer mit der Schalteinrichtung gekoppelten Stromerfassungseinrichtung mit einem Stromsignalausgang, mittels derer ein Stromsignal bildbar und über den Stromsignalausgang abgebbar ist, das die Größe des zwischen dem Versorgungsanschluss und dem Lastanschluss fließenden Laststroms wiedergibt, einem in einem mit dem Stromsignalausgang verbundenen Stromsignalzweig zur Führung des Stromsignals angeordneten elektrischen Bauelement mit einem ohmschen Widerstand und einem mit dem Stromsignalzweig verbundenen Diagnoseausgang, über den eine dem Stromsignal entsprechende Spannung in dem Stromsignalzweig abgebbar ist. Eine Lasteinschaltvorrichtung dieser Art ist beispielsweise aus der US 2002 176215 bekannt. Die Erfindung betrifft ferner ein Verfahren zur Diagnose eines Laststromkreises mit einer solchen Lastschaltvorrichtung.

Lastschaltvorrichtungen der oben genannten Art werden dazu verwendet, Lasten bzw. Verbraucher in einem Laststromkreis unter Verwendung eines der Lastschaltvorrichtung zuzuführenden elektrischen Schaltsignals ein- und auszuschalten, das im Vergleich zu den zu schaltenden Lastströmen klein ist. Vielfach werden Lastschaltvorrichtungen verwendet, die MOSFET-Bauelemente enthalten, denen über "Gate" das Schaltsignal zugeführt wird, das dann den Kanal zwischen den mit einer Versorgungsspannungsquelle und der Last verbundenen Anschlüssen "Source" bzw. "Drain" des MOSFET-Bauelements in einen leitenden oder im Wesentlichen nicht leitenden Zustand schaltet.

Insbesondere im Bereich der Automobiltechnik ist es wünschenswert, überprüfen zu können, ob der Laststromkreis funktionsfähig ist. Zu dieser Diagnose oder Prüfung gehört die Prüfung, dass überhaupt eine Last angeschlossen ist, durch die ein Strom fließen kann. Weiterhin ist es wünschenswert, überprüfen zu können, ob ein Kurzschluss der Last gegenüber Masse bzw. gegenüber einem Pol der Versorgungsstrom- bzw. -spannungsquelle, an dem die Last angeschlossen ist, besteht. Schließlich kann überprüft werden, ob ein Kurzschluss zwischen der Last bzw. den daran angeschlossenen Leitern und dem nicht mit der Last direkt verbunden Pol der Versorgungsstrom- bzw. -spannungsquelle vorliegt. Im Bereich der Automobiltechnik wird diese Prüfung häufig als Prüfung auf einen Kurzschluss gegenüber Batterie bezeichnet, während die davor genannte Prüfung auch Prüfung auf einen "Kurzschluss gegenüber Masse" genannt wird, da in der Automobiltechnik in der Regel ein Anschluss der Last auf Masse liegt.

Grundsätzlich sind solche Diagnosen mit bekannten MOSFET-Bauelementen in so genannter "High-Side"-Schaltung durchführbar, bei der die MOSFET-Bauelemente jeweils zwischen die Last und die Versorgsungsstrom- bzw. -spannungsquelle geschaltet sind. Dazu müssen jedoch bislang intelligente MOSFET-Bauelemente (so genannte Smart MOSFETs) verwendet werden, die über eine eingebaute Logik verfügen. Diese weisen weiterhin eine Strommesseinrichtung bzw. eine sogenannten "Current Sense"-Funktion auf, die ein die Größe des durch das MOSFET-Bauelement fließenden Laststroms wiedergebendes Stromsignal abgibt. Zur Steuerung der Lastschaltvorrichtung und zur Diagnose des Laststromkreises ist dann eine Auswerteeinrichtung, beispielsweise ein Mikrocontroller, notwendig, die einen mit dem "Gate" des MOSFET-Bauelements zu verbindenden Steuersignalausgang, einen Eingang, der mit "Source" des MOSFET-Bauelements, d.h. der Last, verbunden ist, und einen mit dem Stromsignalausgang verbundenen Eingang aufweisen muss. Anhand von Wahrheitstabellen können in Abhängigkeit von den Steuersignalen, den Signalen an "Source" und dem Stromsignalausgang sowie entsprechenden Wahrheitstabellen Diagnosen des Laststromkreises durchgeführt werden.

Dies hat jedoch den Nachteil, dass an dem Mikrocontroller neben dem Steuersignalausgang zwei weitere Eingänge belegt werden. Darüber hinaus muss das MOSFET-Bauelement die zuvor erwähnte Logikfunktion aufweisen, die dessen Preis erhöht.

Insbesondere im Automobilbau ist es jedoch wünschenswert, möglichst einfache Schaltungen zu verwenden, um dadurch Kosten einsparen zu können.

Bei der aus der US 2002 176215 bekannten Lastschaltvorrichtung der eingangs genannten Art ist die Schalteinrichtung durch ein MOSFET-Element mit integrierter "Current Sense"-Funktion gebildet. Dabei wird das eingeschaltete MOSFET-Element auf evtl. auftretende Überströme hin überwacht und das MOSFET-Element bei Überschreiten eines oberen Stromgrenzwertes abgeschaltet.

Eine vergleichbare Lastschaltvorrichtung, bei der die Schalteinrichtung mit integrierter "Current Sense"-Funktion durch ein IGBT-Element gebildet ist, ist aus der EP 1 143 618 bekannt.

Der vorliegenden Erfindung liegt daher die Aufgabe zugrunde, eine Lastschaltvorrichtung zum Öffnen und Schließen eines Laststromkreises in Abhängigkeit von einem Schaltsignal bereitzustellen, mittels dessen eine einfache Diagnose des Laststromkreises möglich ist, sowie ein entsprechendes Verfahren zur Diagnose eines Laststromkreises mit einer solchen Lastschaltvorrichtung anzugeben.

Die Aufgabe wird erfindungsgemäß dadurch gelöst, dass der Lastanschluss über einen zusätzlichen Widerstand mit dem Stromsignalzweig verbunden ist.

Die erfindungsgemäße Lastschaltvorrichtung zum Öffnen und Schließen eines Laststromkreises, der eine zu schaltende elektrischen Last und eine Versorgungsstrom- oder -spannungsquelle umfasst, in Abhängigkeit von einem Schaltsignal, umfasst eine Schalteinrichtung mit einem Schaltsignaleingang, einem Versorgungsanschluss und einem Lastanschluss, mittels derer in Abhängigkeit von dem Schaltsignal an dem Schaltsignal-eingang der Versorgungsanschluss elektrisch mit dem Lastanschluss verbindbar oder von diesem trennbar ist, eine mit der Schalteinrichtung gekoppelte Stromerfassungseinrichtung mit einem Stromsignalausgang, mittels derer ein Stromsignal bildbar und über den Stromsignalausgang abgebbar ist, das die Größe des zwischen dem Versorgungsanschluss und dem Lastanschluss fließenden Laststroms wiedergibt, ein in einem mit dem Stromsignalausgang verbundenen Stromsignalzweig zur Führung des Stromsignals angeordnetes elektrisches Bauelement mit einem ohmschen Widerstand und einen mit dem Stromsignalzweig verbundenen Diagnoseausgang, über den eine dem Stromsignal entsprechende Spannung in dem Stromsignalzweig abgebbar ist, wobei der Lastanschluss mit dem Stromsignalzweig über einen Widerstand verbunden ist.

Die erfindungsgemäße Lastschaltvorrichtung verfügt also über die Schalteinrichtung mit dem Versorgungsanschluss und den Lastanschluss. Der Versorgungsanschluss kann mit einem zu einem Pol der Versorgungsstrom- oder -spannungsquelle führenden, nicht die Last enthaltenden Zweig des Laststromkreises und der Lastanschluss mit einem die Last enthaltenden Zweig des Laststromkreises über entsprechende Leitungen zu verbinden sein. Durch Zuführung eines entsprechenden Schaltsignals zu dem Schaltsignaleingang kann dann der Versorgungsanschluss elektrisch leitend mit dem Lastanschluss verbunden werden, so dass der Laststromkreis geschlossen ist, oder der Versorgungsanschluss kann von dem Lastanschluss getrennt werden, so dass der Laststromkreis geöffnet und die Last dementsprechend ausgeschaltet ist. Bei der Versorgungsstrom- bzw. -spannungsquelle kann es sich beispielsweise um eine Kraftfahrzeugbatterie handeln.

Weiterhin ist die mit der Schalteinrichtung elektrisch bzw. elektronisch gekoppelte Stromerfassungseinrichtung vorgesehen, mittels derer ein Stromsignal abgebbar ist, das die Größe des zwischen dem Versorgungsanschluss und dem Lastanschluss fließenden Laststroms wiedergibt. Je nach Ausführung der Schalteinrichtung bzw. der Stromerfassungseinrichtung kann das Stromsignal insbesondere proportional zu dem zwischen dem Versorgungsanschluss und dem Laststromausgang fließenden Laststrom sein. Die Amplitude des Stromsignals ist dabei in der Regel gegenüber der des Laststroms wesentlich reduziert.

Das Stromsignal wird über einen Stromsignalausgang in einen Stromsignalzweig abgegeben, der mit einem der Pole der Versorgungsstrom- bzw. -spannungsquelle, insbesondere Masse, verbunden sein kann.

In diesem Stromsignalzweig ist das elektrische Bauelement angeordnet, das einen ohmschen Widerstand in dem Signalstromzweig darstellt, über dem eine dem Strom des Stromsignals und damit des Laststroms entsprechende Spannung abfällt.

Weiterhin verfügt die Lastschaltvorrichtung über einen mit dem Stromsignal verbundenen Diagnoseausgang, der so mit dem Stromsignalzweig verbunden ist, dass über diesen eine dem Stromsignal entsprechende Spannung in dem Stromsignalzweig abgebbar ist. Bei dieser Spannung kann es sich um einen Spannungsabfall über wenigstens ein Widerstandselement mit ohmschem Widerstand in dem Stromsignalzweig und insbesondere einen Spannungsabfall über das elektrische Bauelement handeln. Diese Spannung bzw. das Spannungssignal kann zur Diagnose verwendet werden.

Weiterhin ist der Lastanschluss mit dem Stromsignalzweig über einen Widerstand verbunden, so dass je nach Potenzial an dem Lastanschluss Ströme von dem Lastanschluss über den Widerstand in den Stromsignalzweig geführt werden können. Bei diesem Widerstand handelt es sich um einen Widerstand mit einem großen Widerstandswert, der so gewählt ist, dass die bei normalem Betrieb auftretenden Lastströme eine Messung des Laststroms mit der Strommesseinrichtung im Wesentlichen nicht beeinträchtigen. Das bedeutet insbesondere, dass ein Laststromanteil, der über den Widerstand in den Stromsignalzweig geführt werden könnte, den Strom des Stromsignals nicht wesentlich beeinflussen kann. Die Verbindung zu dem Stromsignalzweig erfolgt dabei derart, dass ein über den Widerstand in den Stromsignal fließender Strom in dem Stromsignalzweig über das elektrische Bauelement mit ohmschem Widerstand oder ein weiteres elektrisches Bauelement mit ohmschem Widerstand geleitet wird, an dem dann eine entsprechende, über den Diagnoseausgang abgreifbare Spannung abfällt.

Dadurch, dass der Widerstand mit dem mit der Last zu verbindenden Laststromanschluss verbunden ist, fließt bei einem Kurzschluss des die Last enthaltenden Zweigs des Laststromkreises gegenüber dem nicht mit diesem verbundenen Pol des Laststromkreises ein Strom über den Stromsignalzweig, der, wenn der Versorgungsanschluss und der Lastanschluss nicht durch die Schalteinrichtung miteinander verbunden sind, einen Kurzschluss anzeigt.

Die Aufgabe wird weiterhin gelöst durch ein Verfahren zur Diagnose eines Laststromkreises mit den Merkmalen des Anspruchs 11.

Bei dem erfindungsgemäßen Verfahren zur Diagnose eines Laststromkreises mit einer Versorgungsstrom- oder -spannungsquelle, einer damit verbundenen erfindungsgemäßen Lastschaltvorrichtung und einer mit der Lastschaltvorrichtung und der Versorgungsstrom- oder -spannungsquelle verbundenen Last, wird zur Erkennung eines Defekts der Last oder einer defekten elektrischen Verbindung der Last zu der Lastschaltvorrichtung ein Schaltsignal zur Verbindung von Versorgungs- und Lastanschluss zugeführt, es werden die Anschlüsse miteinander verbunden und dann wird geprüft, ob der Betrag einer Spannung an dem Diagnoseausgang einen vorgegebenen unteren Schwellwert unterschreitet, und/oder es wird zur Erkennung eines Kurzschlusses zwischen dem Lastanschluss und dem mit der Last direkt verbundenen Pol der Versorgungsstrom- oder - spannungsquelle der Lastschaltvorrichtung ein Schaltsignal zur Verbindung von Versorgungs- und Lastanschluss zugeführt, es werden die Anschlüsse miteinander verbunden und es wird dann geprüft, ob der Betrag einer Spannung an dem Diagnoseausgang einen vorgegebenen ersten oberen Schwellwert überschreitet, und es wird zur Erkennung eines Kurzschlusses der Last gegenüber dem direkt mit dem Versorgungsanschluss verbundenen Pol der Versorgungsstrom- oder -spannungsquelle ein Schaltsignal zur Trennung von Versorgungs- und Lastanschluss zugeführt, eine Verbindung zwischen dem Versorgungs- und dem Lastanschluss getrennt und geprüft, ob der Betrag einer Spannung an dem Diagnoseausgang einen vorgegebenen zweiten oberen Schwellwert überschreitet.

Unter einer direkten Verbindung wird dabei nur verstanden, dass die Verbindung nicht über die Lastschaltvorrichtung erfolgt. Es können aber noch andere Bauelemente darin vorgesehen sein.

Zur Diagnose des Laststromkreises sind also erfindungsgemäß nur zwei Anschlüsse für eine Steuer- und Auswerteeinrichtung notwendig, von denen der eine, nämlich der Schaltsignalausgang, über den das Schaltsignal dem Schaltsignaleingang der Schalteinrichtung zuführbar ist, ohnehin vorhanden sein muss, um die Schalteinrichtung betätigen zu können.

Darüber hinaus kann die Verwendung eines intelligenten MOSFET-Bauelements mit einer integrierten Logik vermieden werden.

Es ergeben sich so eine Lastschaltvorrichtung und ein Diagnoseverfahren, die bzw. das sehr einfach und unter geringen Kosten eine Diagnose eines Laststromkreises erlaubt.

Weiterbildungen und bevorzugte Ausführungsformen der Erfindung sind in den Ansprüchen, der Beschreibung und den Zeichnungen beschrieben.

Um einerseits noch kleine Stromsignale erfassen zu können, wie sie bei sehr kleinen Lastströmen und insbesondere bei einer Prüfung auf einen Defekt der Last oder Lastverbindungen auftreten können, und andererseits auch angepasste Spannungen bei Auftreten eines Kurzschlusses gegenüber der Versorgungsstrom- bzw. -spannungsquelle zu erhalten, ist es bevorzugt, dass das elektrische Bauelement eine nichtlineare Strom-Spannungs-Kennlinie aufweist.

Um bei einer Prüfung, ob eine Last defekt ist und daher kein Laststrom fließt, mit hoher Genauigkeit durchführen zu können, ist es wünschenswert, dass die Spannung an dem Diagnoseausgang bei abnehmenden Stromstärken des Stromsignals nicht proportional abnehmen. Es ist daher insbesondere bevorzugt, dass der differentielle Widerstand des elektrischen Bauelements mit abnehmenden Stromstärken zunimmt. Es kann dann bei kleinen Strömen ein großer differentieller Widerstand auftreten, der zu einem vergleichsweise großen Spannungsabfall führt, der eine Erfassung der Größe des Laststroms mit erhöhter Genauigkeit zulässt.

Um die Lastschaltvorrichtung gegen Schäden durch einen falschen Anschluss, insbesondere einer Vertauschung der Pole der Versorgungsstrom- bzw. -spannungsquelle, zu schützen, ist es bevorzugt, dass in dem Signalstromzweig ein elektrisches Bauelement angeordnet ist, mittels dessen ein durch den Stromsignalzweig bei normaler Verwendung entgegen der Richtung des Stroms des Stromsignals fließender Strom sperrbar ist.

Besonders bevorzugt wird als elektrisches Bauelement eine Diode verwendet. Eine entsprechend geschaltete Diode besitzt nicht nur eine geeignete Strom-Spannungs-Kennlinie, sondern kann gleichzeitig als sperrendes Bauelement wirken.

Um zum einen den Strom in dem Stromsignalzweig begrenzen zu können und zum anderen einen größeren Spannungsabfall zu erhalten, ist es weiter bevorzugt, dass das elektrische Bauelement in einer Reihenschaltung mit einem weiteren Widerstand angeordnet ist.

Grundsätzlich können bei der erfindungsgemäßen Lastschaltvorrichtung beliebige Schalteinrichtungen und Stromerfassungseinrichtungen verwendet werden. Um einen besonders einfachen und kostengünstigen Aufbau zu erreichen, ist es jedoch bevorzugt, dass die Schalteinrichtung und die Stromerfassungseinrichtung durch ein MOSFET-Bauelement mit Stromerfassung gebildet werden. Ein solches MOSFET-Bauelement mit Stromerfassung ("Current-Sense"-Funktion) bzw. Strommessung ist sehr gebräuchlich und daher kostengünstig. Bedingt durch die erfindungsgemäße Schaltung braucht dieses auch keinen Logikabschnitt aufzuweisen, was zusätzlich die Kosten senkt.

Dabei ist es besonders bevorzugt, dass die Schalteinrichtung so ausgelegt ist, dass der Versorgungsanschluss mit einem Pluspol der Versorgungsstrom- oder -spannungsquelle und der Lastanschluss mit der Last zu verbinden ist. Diese sehr gebräuchliche, auch als "High-Side"-Schaltung bezeichnete Anordnung erlaubt es in besonders einfacher Weise, die Lastschaltvorrichtung für den Gebrauch in Kraftfahrzeugen auszubilden, bei denen häufig die Lasten fest mit Masse bzw. dem Minuspol der Batterie verbunden sind.

Weiterer Gegenstand der Erfindung ist eine Treibervorrichtung mit einer erfindungsgemäßen Lastschaltvorrichtung und einer Diagnoseeinrichtung mit einem mit dem Diagnoseausgang verbundenen Diagnoseeingang, mittels derer ein erstes Kurzschlusssignal abgebbar ist, wenn bei einem Schaltsignal, bei dem der Versorgungsanschluss mit dem Lastanschluss verbunden ist, der Strom des Stromsignals einen vorgegebenen ersten oberen Schwellwert betragsmäßig überschreitet, und/oder mittels derer ein zweites Kurzschlusssignal abgebbar ist, wenn bei einem Schaltsignal, bei dem der Versorgungsanschluss von dem Lastanschluss getrennt ist, der Strom des Stromsignals einen vorgegebenen zweiten oberen Schwellwert betragsmäßig überschreitet, und/oder mittels derer ein Trennsignal ausgebbar ist, wenn bei einem Schaltsignal, bei dem der Versorgungsanschluss mit dem Lastanschluss verbunden ist, der Strom des Stromsignals einen vorgegebenen unteren Schwellwert betragsmäßig unterschreitet. Mit einer solchen Treibervorrichtung ist das erfindungsgemäße Verfahren einfach durchführbar, da die Diagnoseeinrichtung die Diagnose des Laststromkreises vereinfacht. Dabei braucht in der Diagnoseeinrichtung nicht der Strom selbst überprüft zu werden, sondern es kann auch üblicherweise die dem Stromsignal entsprechende Spannung bzw. das entsprechende Spannungssignal daraufhin überprüft werden, ob es vorgegebene entsprechende Spannungsschwellwerte über- bzw. unterschreitet. Die Schwellwerte können insbesondere in Abhängigkeit von den auftretenden Spannungen und damit den verwendeten Widerständen sowie den maximal auftretenden Last- bzw. Kurzschlussströmen gewählt werden.

Hierzu ist es besonders bevorzugt, dass die Diagnoseeinrichtungen einen Analog-Digital-Wandler umfasst, mit dessen Eingang mit dem Diagnoseausgang verbunden ist. Auf diese Weise können zusätzlich Messungen in Bezug auf die Stärke des Laststroms durchgeführt werden, indem entsprechende Digitalwerte des Analog-Digital-Wandlers verwendet werden, wobei die nichtlineare Kennlinie des elektrischen Bauelements berücksichtigt werden kann.

Weiterhin ist es bevorzugt, dass eine Steuer- und Auswerteeinrichtung mit einem Steuersignaleingang vorgesehen ist, mittels derer auf ein Steuersignal hin entsprechende Schaltsignale bildbar sind, die einen mit dem Schaltsignaleingang verbundenen Schaltsignalausgang zur Abgabe digitaler Schaltsignale aufweist. Die Steuer- und Auswerteeinrichtung kann weiterhin Eingänge aufweisen, über die Steuersignale zuführbar sind, auf deren Basis Schaltsignale gebildet und über den Schaltsignalausgang ausgegeben werden.

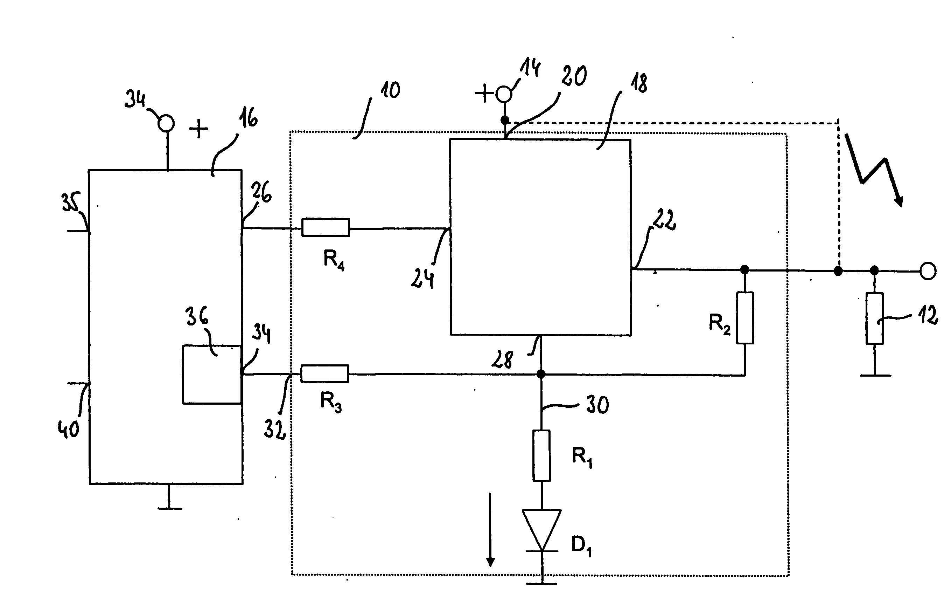

Die Erfindung wird nun weiter beispielhaft anhand der Zeichnungen erläutert. Die einzige Zeichnung zeigt einen Laststromkreis mit einer Last und einer Treibervorrichtung mit einer Lastschaltvorrichtung nach einer bevorzugten Ausführungsform der Erfindung.

In der Figur umfasst eine Treibervorrichtung nach einer bevorzugten Ausführungsform der Erfindung eine Lastschaltvorrichtung 10, die mit einer Last 12 und einer Versorgungsspannungsquelle 14 in Form einer Kraftfahrzeugbatterie verbunden ist, und eine Steuer- und Auswerteeinrichtung 16.

Die Lastschaltvorrichtung 10 verfügt über ein n-Kanal-MOSFET-Bauelement 18 mit einer Strommessung. Das MOSFET-Bauelement 18 ist in einer so genannten "High-Side"-Konfiguration angeordnet, bei der der "Drain"-Anschluss als Versorgungsanschluss 20 dient und mit dem Pluspol der Versorgungsspannungsquelle 14 verbunden ist, während der als Lastanschluss 22 dienende "Source"-Anschluss zu der Last 12 führt. Der Minuspol der Versorgungsstrom- bzw. -spannungsquelle 14 ist mit Masse verbunden, auf der auch ein entsprechender Anschluss der Last 12 liegt.

Ein als Schaltsignaleingang 24 dienender "Gate"-Anschluss des MOSFET-Bauelements 18 ist über einen Schutzwiderstand R₄ mit der Steuer- und Auswerteeinrichtung 16 über deren Schaltsignalausgang 26 verbunden.

Das MOSFET-Bauelement 18 bildet insofern eine Schalteinrichtung im Sinne der Erfindung.

Eine Stromerfassung bzw. Strommessung ("Current Sense"-Funktion) des MOSFET-Bauelements 18 erzeugt Stromsignale, deren Stromstärke die Stärke eines zwischen dem Versorgungsanschluss 20 und dem Lastanschluss 22 durch den Kanal des MOSFET-Bauelements 18 fließenden Laststroms wiedergibt. Das Stromsignal wird über einen Stromsignalausgang 28 ausgegeben, der über einen Stromsignalzweig 30 mit Masse verbunden ist. In dem Stromsignalzweig 30 sind in einer Reihenschaltung ein Widerstand R₁ und eine Diode D₁ angeordnet.

Zwischen dem Lastanschluss 22 und dem Stromsignalausgang 28 ist weiterhin ein großer Widerstand R₂ angeordnet. Der Widerstand R₂ ist dabei so groß gewählt, dass bei normalem Betrieb ein über diesen fließender Anteil des Laststroms von dem Lastanschluss 22 zu dem Stromsignalzweig 30 gegenüber dem Strom des Stromsignals vernachlässigbar ist, d.h. die Stromerfasssung bzw. -messung des MOSFET-Bauelements 18 nicht stört. Im Beispiel kann er einen Widerstand von etwa 10 MΩ aufweisen.

Zur Ausgabe eines Spannungssignals, das der Stromstärke eines über den Stromsignalausgang 28 ausgegebenen Stromsignals entspricht, ist der Stromsignalausgang 28 weiterhin über einen Schutzwiderstand R₃ mit einem Diagnoseausgang 32 der Lastschaltvorrichtung 10 verbunden.

Die durch einen entsprechend programmierten Mikrocontroller gebildete Steuer- und Auswerteeinrichtung 16 dient zur Steuerung der Lastschaltvorrichtung 10 und der Auswertung der von dieser abgegebenen Diagnosesignale. Sie wird über eine weitere Spannungsversorgung 34 mit Spannung versorgt.

Die Steuer- und Auswerteeinrichtung 16 verfügt über einen Steuereingang 35, beispielsweise für eine Bus, über den Steuersignale zuführbar sind, und ist weiter dazu ausgebildet, auf die Steuersignale hin über den Schaltsignalausgang 26 auszugebenden Schaltsignalen zu bilden und auszugeben.

Die Steuer- und Auswerteeinrichtung 16 verfügt zur Auswertung der Diagnosesignale weiterhin über einen mit dem Diagnoseausgang 32 verbundenen analogen Diagnoseeingang 34, an den ein Analog-Digital-Wandler 36 angeschlossen ist, der an dem Diagnoseeingang 34 anliegende analoge Spannungen in Digitalsignale umsetzt.

Die Steuer- und Auswerteeinrichtung 22 ist weiterhin zur Durchführung des im Folgenden geschilderten Diagnoseverfahrens ausgebildet, wozu sie neben den Spannungssignalen an dem Diagnoseeingang 34 aus den Steuersignalen gebildete Signale verwendet. Fehlersignale können über einen Fehlersignalausgang 40 ausgegeben werden.

Die Treibervorrichtung mit der Lastschaltvorrichtung 10 arbeitet folgendermaßen:

Auf die Zuführung entsprechender Steuersignale zu der Steuer- und Auswerteeinrichtung 18 gibt diese über den Schaltsignalausgang 26 Schaltsignale an den Schaltsignaleingang 24 des MOSFET-Bauelements 18 ab. In Abhängigkeit von diesen Schaltsignalen wird der Kanal zwischen dem Versorgungsanschluss 20 und dem Lastanschluss 22, d.h. "Drain" und "Source" leitend oder auch im Wesentlichen nicht leitend geschaltet, so dass im ersten Fall Strom durch den durch die Versorgungsspannungsquelle 14 und die Last 12 gebildeten Laststromkreis fließen kann, während dieser im anderen Fall geöffnet ist.

Fließt zwischen dem Versorgungsanschluss 20 und dem Lastanschluss 22 ein Laststrom, so wird über die Stromerfassung bzw. -messung des MOSFET-Bauelements 18, die eine Stromerfassungseinrichtung im Sinne der Erfindung bildet, über den Stromsignalausgang 28 ein Stromsignal ausgegeben, dessen die Größe des Laststroms wiedergebender Strom durch den Stromsignalzweig 30 über die Reihenschaltung des Widerstands R₁ und die Diode D₁ zu Masse fließt. Dabei entsteht ein Spannungsabfall über dem Widerstand R₁ und der Diode D₁, der über den Diagnoseausgang 32 dem Diagnoseeingang 34 der Steuer- und Auswerteeinrichtung 16 zuführbar ist.

Bedingt durch die nichtlineare Kennlinie der Diode D₁ ergeben sich bei kleinen Strömen des Stromsignals überproportional große Spannungen, da der differentielle Widerstand der Diode D₁ mit zunehmenden Stromstärken abnimmt. Hierdurch wird eine sehr genaue Erfassung kleiner Ströme gewährleistet.

Bei einer Vertauschung der Pole der Versorgungsspannungsquelle 14 liegt der Pluspol an der Diode D₁ an, die jedoch dann in Sperrrichtung geschaltet ist, so dass keine Ströme durch das MOSFET-Bauelement 18 fließen können, die dieses beschädigen könnten.

Zur Diagnose des Laststromkreises gemäß einem Diagnoseverfahren nach einer bevorzugten Ausführungsform der Erfindung kann zum einen von der Steuer- und Auswerteeinrichtung 16 ein Schaltsignal dem Schaltsignaleingang 24 zugeführt werden, das bewirkt, dass der Versorgungsanschluss 20 und der Lastanschluss 22 leitend miteinander verbunden werden, so dass von daher die Versorgungsspannungsquelle 14 mit der Last 12 verbunden sein könnte.

Zur Prüfung, ob ein Defekt der Last 12 oder ein Defekt in der Verbindung der Last 12 zu Masse oder zu der Lastschaltvorrichtung 12 besteht oder ob ein Kurzschluss zwischen der Verbindung zwischen der Last 12 und dem Lastanschluss 22 und Masse besteht, wird die Größe des über den Stromsignalausgang 26 abgegebenen Stromsignals überprüft. Hierzu wird der entsprechende Spannungsabfall bzw. die entsprechende Spannung an dem Diagnoseausgang 32 dem Diagnoseeingang 34 der Steuer- und Auswerteeinrichtung 16 zugeführt und dort mit dem Analog-Digital-Wandler 36 einer Analog-Digital-Wandlung unterzogen. Die entsprechenden digitalen Werte werden dann von entsprechenden Vergleichsmitteln der Steuer- und Auswerteschaltung 16 laufend daraufhin überprüft, ob sie einen vorgegebene ersten oberen oder einen unteren Schwellwert zur Erkennung eines Kurzschlusses gegen Masse bzw. eines Defekts der Last oder deren Verbindung über- bzw. unterschreiten.

Liegt ein Defekt in der Last 12 oder in der Verbindung der Last 12 mit Masse oder dem Lastanschluss 22 vor, so fließt zwischen dem Versorgungsanschluss 20 und dem Lastanschluss 22 kein Strom. Das entsprechende Stromsignal hat dementsprechend eine verschwindende Größe, so dass die an dem Diagnoseausgang 32 anliegende Spannung einen entsprechend kleinen bzw. verschwindenden Wert hat. Bei der Überprüfung der von dem Analog-Digital-Wandler 36 erzeugten Spannungswerte wird bei Unterschreiten des unteren Schwellwertes dann ein entsprechendes Fehlersignal über den Fehlersignalausgang 40 ausgegeben, das in Abhängigkeit von dem anliegenden Schaltsignal gebildet wird. Bei einer Auflösung des Analog-Digital-Wandlers von 8 Bit kann dieser untere Schwellwert beispielsweise bei etwa 25 liegen.

Tritt in der Verbindung zwischen der Last 12 und dem Lastanschluss 22 ein Kurzschluss gegen Masse auf, fließt ein maximal möglicher Strom vom Versorgungsanschluss 20 zu dem Lastanschluss 22, der dann mit Masse verbunden ist, so dass das Stromsignal, das über den Stromsignalausgang 28 dem Stromsignalzweig 30 zugeführt wird, eine maximale Stärke hat. Diesem entspricht ein sehr großer Spannungswert der an dem Diagnoseausgang 32 anliegenden Spannung. Bei Überwachung der von dem Analog-Digital-Wandler 36 gebildeten Spannungswerte wird daher bei Überschreiten des vorgegebenen ersten oberen Grenzwertes, der im Beispiel bei etwa 250 liegen kann, und bei einem Schaltsignal, das einer Verbindung zwischen dem Versorgungsanschluss 20 und dem Lastanschluss 22 entspricht, ein Fehlersignal gebildet und über den Fehlersignalausgang 40 ausgegeben, das anzeigt, dass ein Kurzschluss der Last gegenüber Masse vorliegt.

Zur Überprüfung eines Kurzschlusses gegenüber Batterie, d.h. dem positiven Pol der Versorgungsspannungsquelle 14, wird ein Schaltsignal dem Schaltsignaleingang 24 zugeführt, durch das der Versorgungsanschluss 20 und der Lastanschluss 22 elektrisch im Wesentlichen voneinander isoliert werden. Liegt in dem Laststromkreis kein Fehler vor, dürfte also kein Strom fließen.

Bei einem Kurzschluss gegenüber Batterie - in der Figur durch eine gestrichelte Linie angedeutet - liegt der Lastanschluss 22 bzw. die Last 12 auf dem Potential des Plus-Pols der Versorgungsspannungsquelle 14, so dass, da der Versorgungsanschluss 20 und der Lastanschluss 22 elektrisch voneinander getrennt sind, ein entsprechender Strom über den Widerstand R₂ in den Stromsignalzweig 30 und von dort zu Masse fließt. Hierdurch wird ein Spannungsabfall über den Widerstand R₁ und die Diode D₁ erzeugt, der dann an dem Diagnoseausgang 32 anliegt. Entsprechend dem Zustand des MOSFET-Bauelements 18 muss dabei die gesamte Spannung dem über dem Widerstand R₂ fließenden Strom entsprechen.

Bei einem Vergleich des Wertes dieser Spannung nach Analog-Digital-Wandlung durch den Analog-Digital-Wandler 36 mit einem zweiten oberen Schwellwert, der im Beispiel bei etwa 10 liegen kann, kann bei einem Überschreiten dieses zweiten oberen Schwellwertes erkannt werden, dass ein Kurzschluss gegenüber Batterie vorliegt. Bei Vorliegen des entsprechenden Schaltsignals, demgemäß die Last abgeschaltet ist, und bei Überschreiten des zweiten oberen Schwellwertes wird daher ein entsprechendes Fehlersignal über den Fehlersignalausgang 40 ausgegeben, das diesen Fehler wiedergibt.

Sowohl die Lastschaltvorrichtung als auch das Diagnoseverfahren zeichnen sich durch große Einfachheit aus. Insbesondere kann bei der Lastschaltvorrichtung 10 ein sehr einfaches MOSFET-Bauelement 18 ohne Logik verwendet werden, wobei zusätzlich nur noch die Diode D₁, gegebenenfalls der Widerstand R₁ sowie der Widerstand R₂ notwendig sind.

Die durch einen Mikrocontroller gebildete Steuer-Auswerteeinrichtung 16 braucht dabei nur den ohnehin notwendigen Schaltsignalausgang 26 und den Diagnoseeingang 34 bereitzustellen, so dass insgesamt nur zwei Anschlüsse bzw. Pins je angeschlossene Lastschaltvorrichtung notwendig sind.

### Bezugszeichenliste

- 10: Lastschaltvorrichtung
- 12: Last
- 14: Versorgungsspannungsquelle
- 16: Steuer- und Auswerteeinrichtung
- 18: MOSFET-Bauelement
- 20: Versorgungsanschluss
- 22: Lastanschluss
- 24: Schaltsignaleingang
- 26: Schaltsignalausgang
- 28: Stromsignalausgang
- 30: Stromsignalzweig
- 32: Diagnoseausgang
- 34: Diagnoseeingang
- 35: Steuereingang
- 36: Analog-Digital-Wandler
- 38: weitere Spannungsversorgung
- 40: Fehlersignalausgang

- D₁: Diode
- R₁: Widerstand
- R₂: Widerstand
- R₃: Schutzwiderstand
- R₄: Schutzwiderstand

## Patentansprüche

1. Lastschaltvorrichtung zum Öffnen und Schließen eines Laststromkreises, der eine zu schaltende elektrische Last (12) und eine Versorgungsstrom- oder -spannungsquelle (14) umfasst, in Abhängigkeit von einem Schaltsignal, mit
einer Schalteinrichtung (18) mit einem Schaltsignaleingang (24),
einem Versorgungsanschluss (20) und einem Lastanschluss (22), mittels derer in Abhängigkeit von dem Schaltsignal an dem Schaltsignaleingang (24) der Versorgungsanschluss (20) elektrisch mit dem Lastanschluss (22) verbindbar oder von diesem trennbar ist,
einer mit der Schalteinrichtung (18) gekoppelten Stromerfassungseinrichtung (18) mit einem Stromsignalausgang (28), mittels derer ein Stromsignal bildbar und über den Stromsignalausgang (28) abgebbar ist, das die Größe des zwischen dem Versorgungsanschluss (20) und dem Lastanschluss (22) fließenden Laststroms wiedergibt, einem in einem mit dem Stromsignalausgang (28) verbundenen Stromsignalzweig (30) zur Führung des Stromsignals angeordneten elektrischen Bauelement (D₁) mit einem ohmschen Widerstand und einem mit dem Stromsignalzweig (30) verbundenen Diagnoseausgang (32), über den eine dem Stromsignal entsprechende Spannung in dem Stromsignalzweig (30) abgebbar ist,
**dadurch gekennzeichnet, dass**
der Lastanschluss (22) über einen zusätzlichen Widerstand (R₂) mit dem Stromsignalzweig (30) verbunden ist.

2. Lastschaltvorrichtung nach Anspruch 1,
**dadurch gekennzeichnet,**
**dass** das elektrische Bauelement (D₁) eine nichtlineare Strom-Spannungs-Kennlinie aufweist.

3. Lastschaltvorrichtung nach Anspruch 1 oder 2,
**dadurch gekennzeichnet,**
**dass** der differentielle Widerstand des elektrischen Bauelements (D₁) mit abnehmendem Stromwerten zunimmt.

4. Lastschaltvorrichtung nach Anspruch 3,
**dadurch gekennzeichnet,**
**dass** das elektrische Bauelement eine Diode (D₁) ist.

5. Lastschaltvorrichtung nach einem der vorhergehenden Ansprüche,
**dadurch gekennzeichnet,**
**dass** das elektrische Bauelement (D₁) in einer Reihenschaltung mit einem weiteren Widerstand (R₁) angeordnet ist.

6. Lastschaltvorrichtung nach einem der vorhergehenden Ansprüche,
**dadurch gekennzeichnet,**
**dass** die Schalteinrichtung und die Stromerfassungseinrichtung durch ein MOSFET-Bauelement (18) mit Stromerfassung gebildet werden.

7. Lastschaltvorrichtung nach einem der vorhergehenden Ansprüche,
**dadurch gekennzeichnet,**
**dass** die Schalteinrichtung so ausgelegt ist, dass der Versorgungsanschluss (20) mit einem Pluspol der Versorgungsstrom- oder -spannungsquelle (14) und der Lastanschluss (22) mit der Last (12) zu verbinden ist.

8. Treibervorrichtung mit
einer Lastschaltvorrichtung (10) nach einem der vorhergehenden Ansprüche und
einer Diagnoseeinrichtung mit einem mit dem Diagnoseausgang (32) verbundenen Diagnoseeingang (34), mittels derer ein erstes Kurzschlusssignal abgebbar ist, wenn bei einem Schaltsignal, bei dem der Versorgungsanschluss mit dem Lastanschluss verbunden ist, der Strom des Stromsignals einen vorgegebenen ersten oberen Schwellwert betragsmäßig überschreitet, und/oder mittels derer ein zweites Kurzschlusssignal abgebbar ist, wenn bei einem Schaltsignal, bei dem der Versorgungsanschluss (20) von dem Lastanschluss (22) getrennt ist, der Strom des Stromsignals einen vorgegebenen zweiten oberen Schwellwert betragsmäßig überschreitet, und/oder mittels derer ein Trennsignal ausgebbar ist, wenn bei einem Schaltsignal, bei dem der Versorgungsanschluss (20) mit dem Lastanschluss (22) verbunden ist, der Strom des Stromsignals einen vorgegebenen unteren Schwellwert betragsmäßig unterschreitet.

9. Treibervorrichtung nach Anspruch 8,
**dadurch gekennzeichnet,**
**dass** die Diagnoseseinrichtung einen A/D-Wandler (36) umfasst, dessen Eingang mit dem Diagnoseeingang (34) verbunden ist.

10. Treibervorrichtung nach Anspruch 8 oder 9,
**dadurch gekennzeichnet,**
**dass** eine die Diagnoseeinrichtung umfassende Steuer- und Auswerteeinrichtung (12) mit einem Steuersignaleingang vorgesehen ist, mittels derer auf ein Steuersignal hin entsprechende Schaltsignale bildbar sind, und
die einen mit dem Schaltsignaleingang verbundenen Schaltsignalausgang (26) zur Abgabe digitaler Schaltsignale aufweist.

11. Verfahren zur Diagnose eines Laststromkreises mit einer Versorgungsstrom- oder -spannungsquelle (14), einer damit verbundenen Lastschaltvorrichtung (10) nach einem der Ansprüche 1 bis 7 und einer mit der Lastschaltvorrichtung (10) und der Versorgungsstrom- oder -spannungsquelle (14) verbundenen Last (12),
bei dem
zur Erkennung eines Defekts der Last (12) oder einer defekten elektrischen Verbindung der Last (12) zu der Lastschaltvorrichtung (10) ein Schaltsignal zur Verbindung von Versorgungs- und Lastanschluss (20, 22) zugeführt wird, die Anschlüsse (20, 22) miteinander verbunden werden und dann geprüft wird, ob der Betrag einer Spannung an dem Diagnoseausgang (32) einen vorgegebenen unteren Schwellwert unterschreitet, und/oder
zur Erkennung eines Kurzschlusses zwischen dem Lastanschluss (22) und dem mit der Last (10) direkt verbundenen Pol der Versorgungsstrom- oder -spannungsquelle (12) der Lastschaltvorrichtung (10) ein Schaltsignal zur Verbindung von Versorgungs- und Lastanschluss (20, 22) zugeführt wird, die Anschlüsse (20, 22) miteinander verbunden werden und dann geprüft wird, ob der Betrag einer Spannung an dem Diagnoseausgang (32) einen vorgegebenen ersten oberen Schwellwert überschreitet, und
zur Erkennung eines Kurzschlusses der Last (12) gegenüber dem direkt mit dem Versorgungsanschluss (20) verbundenen Pol der Versorgungsstrom- oder -spannungsquelle (14) ein Schaltsignal zur Trennung von Versorgungs- und Lastanschluss (20, 22) zugeführt, eine Verbindung zwischen dem Versorgungs- und dem Lastanschluss (20, 22) getrennt und geprüft wird, ob der Betrag einer Spannung an dem Diagnoseausgang (32) einen vorgegebenen zweiten oberen Schwellwert überschreitet.

## Claims

1. Load switching apparatus for opening and closing, in dependence on a switching signal, a load supply circuit having an electrical load (12) which is to be switched and a current supply source or a voltage supply source (14), the apparatus comprising
a switching device (18) with a switching signal input (24), a supply terminal (20) and a load terminal (22) whereby, by means of the switching device (18), the supply terminal (20) can be electrically connected to or separated from the load terminal (22) in dependence on the switching signal at the switching signal input (24),
a current measurement device (18) which is coupled to the switching device (18) and has a current signal output (28) by means of which a current signal can be formed and transmitted via the current signal output (28) which reflects the magnitude of the load current flowing between the supply terminal (20) and the load terminal (22),
an electrical component (D₁) with an ohmic resistance which is arranged in a current signal branch (30) connected to the current signal output (28) for conducting the current signal and
a diagnosis output (32) connected to the current signal branch (30) and via which a voltage corresponding to the current signal can be transmitted in the current signal branch (30), **characterized in that** the load terminal (22) is connected to the current signal branch (30) via an additional resistor (R₂).

2. Load switching apparatus in accordance with claim 1,
**characterized in that**,
the electrical component (D₁) has a nonlinear current-voltage characteristic

3. Load switching apparatus in accordance with claim 1 or claim 2,
**characterized in that**,
the differential resistance of the electrical component (D₁) increases with decreasing current values.

4. Load switching apparatus in accordance with claim 3,
**characterized in that**,
the electrical component is a diode (D₁).

5. Load switching apparatus in accordance with any one of the preceding claims,
**characterized in that**,
the electrical component (D₁) is arranged in a series circuit with a further resistor (R₁).

6. Load switching apparatus in accordance with any one of the preceding claims,
**characterized in that**,
the switching device and the current measurement device are formed by a MOSFET component (18) with current measurement.

7. Load switching apparatus in accordance with any one of the preceding claims,
**characterized in that**,
the switching device is designed such that the supply terminal (20) is to be connected to a positive pole of the current supply source or voltage supply source (14) and the load terminal (22) is to be connected to the load (12).

8. Driver apparatus comprising
a load switching apparatus (10) in accordance with any one of the preceding claims and
a diagnosis device having a diagnosis input (34) connected to the diagnosis output (32) and by means of which a first short circuit signal can be transmitted when, with a switching signal in which the supply terminal is connected to the load terminal, the current of the current signal exceeds a predetermined first upper threshold value in magnitude, and/or by means of which a second short circuit signal can be transmitted when, with a switching signal in which the supply terminal (20) is separated from the load terminal (22), the current of the current signal exceeds a predetermined second upper threshold value in magnitude, and/or by means of which a separation signal can be transmitted when, with a switching signal in which the supply terminal (20) is connected to the load terminal (22) the current of the current signal lies below a predetermined lower threshold value in magnitude.

9. Driver apparatus in accordance with claim 8,
**characterized in that**,
the diagnosis device comprises an A/D converter (36), the input of which is connected to the diagnosis input (34).

10. Driver apparatus in accordance with claim 8 or claim 9,
**characterized in that**,
a control and evaluation device (12) including the diagnosis device is provided with a control signal input by means of which corresponding switching signals can be formed in response to a control signal, and
the control and evaluation device has a switching signal output (26) which is connected to the switching signal input for the transmission of digital switching signals.

11. Method for the diagnosis of a load current circuit comprising a current supply source or voltage supply source (14), a load switching apparatus (10) in accordance with any one of the claims 1 to 7 which is connected to it and a load (12) which is connected to the load switching apparatus (10) and the current supply source or voltage supply source (14),
in which,
for the detection of a defect in the load (12) or of a defective electrical connection of the load (12) to the load switching apparatus (10), a switching signal for the connection of the supply and load terminals (20, 22) is supplied, the terminals (20, 22) are connected to one another and a test is then made whether the magnitude of a voltage at the diagnosis output (32) lies below a predetermined lower threshold value, and/or,
for the detection of a short circuit between the load terminal (22) and the pole of the current supply source or voltage supply source (14) of the load switching apparatus (10) which is directly connected to the load (12), a switching signal for connection of the supply and load terminals (20, 22) is supplied, the terminals (20, 22) are connected to one another and a test is then made whether the magnitude of a voltage at the diagnosis output (32) exceeds a predetermined first upper threshold value, and/or,
for the detection of a short circuit of the load (12) with respect to the pole of the current supply source or voltage supply source (14) which is directly connected to the supply terminal (20) a switching signal for separating the supply and load terminals (20, 22) is supplied, a connection between the supply and load terminals (20, 22) is separated and a test is made whether the magnitude of a voltage at the diagnosis output (32) exceeds a predetermined second upper threshold value.

## Revendications

1. Dispositif de commutation de charge pour ouvrir et fermer un circuit de courant de charge, qui comprend une charge électrique à commuter (12) et une source de courant ou de tension d'alimentation (14), en fonction d'un signal de commutation, avec
un système de commutation (18) doté d'une entrée de signaux de commutation (24), d'une connexion d'alimentation (20) et d'une connexion de charge (22), au moyen duquel la connexion d'alimentation (20) peut être reliée avec ou séparée électriquement de la connexion de charge (22) en fonction du signal de commutation à l'entrée de signaux de commutation (24),
un système de détection de courant (18) doté d'une sortie de signaux de courant (28) couplé au système de commutation (18), au moyen duquel un signal de courant peut être généré et émis sur la sortie de signaux de courant (28), qui exprime la grandeur du courant de charge circulant entre la connexion d'alimentation (20) et la connexion de charge (22), un composant électrique (D₁) monté dans une branche de signaux de courant (30) reliée à la sortie de signaux de courant (28) pour transmettre le signal de courant avec une résistance ohmique et une sortie de diagnostic (32) reliée à la branche de signaux de courant (30), par lequel une tension correspondant au signal de courant peut être émise dans la branche de signaux de courant (30),
**caractérisé en ce que**
la connexion de charge (22) est reliée avec la branche de signaux de courant (30) par une résistance supplémentaire (R₂).

2. Dispositif de commutation de charge selon la revendication 1,
**caractérisé en ce que**
le composant électrique (D₁) possède une courbe caractéristique courant/tension non linéaire.

3. Dispositif de commutation de charge selon la revendication 1 ou 2,
**caractérisé en ce que**
la résistance différentielle du composant électrique (D₁) augmente lorsque la valeur du courant diminue.

4. Dispositif de commutation de charge selon la revendication 3,
**caractérisé en ce que**
le composant électrique est une diode (D₁).

5. Dispositif de commutation de charge selon une des revendications précédentes,
**caractérisé en ce que**
le composant électrique (D₁) est monté en série avec une autre résistance (R₁).

6. Dispositif de commutation de charge selon une des revendications précédentes,
**caractérisé en ce que**
le système de commutation et le système de détection de courant sont constitués par un composant MOSFET (18) à détection de courant.

7. Dispositif de commutation de charge selon une des revendications précédentes,
**caractérisé en ce que**
le système de commutation est conçu de telle sorte que la connexion d'alimentation doit être reliée avec un pôle positif de la source de courant ou de tension d'alimentation (14) et la connexion de charge (22) avec la charge (12).

8. Dispositif de déclenchement doté
d'un dispositif de commutation de charge (10) selon une des revendications précédentes et
d'un système de diagnostic avec une entrée de diagnostic (34) reliée à la sortie de diagnostic (32), au moyen duquel un premier signal de court-circuit peut être émis lorsque, lors d'un signal de commutation pendant lequel la connexion d'alimentation est reliée avec la connexion de charge, le courant du signal de courant est supérieur à une première valeur seuil supérieure prédéfinie, et/ou au moyen duquel, lorsque, lors d'un signal de commutation pendant lequel la connexion d'alimentation (20) est séparée de la connexion de charge (22), le courant du signal de courant est supérieur à une deuxième valeur seuil supérieure prédéfinie, et/ou au moyen duquel un signal de séparation peut être émis lorsque, lors d'un signal de commutation pendant lequel la connexion d'alimentation (20) est reliée avec la connexion de charge (22), le courant du signal de courant est inférieur à une valeur seuil inférieure prédéfinie.

9. Dispositif de déclenchement selon la revendication 8
**caractérisé en ce que**
le système de diagnostic comprend un convertisseur A/N (36) dont l'entrée est reliée avec la sortie de diagnostic (34).

10. Dispositif de déclenchement selon la revendication 8 ou 9
**caractérisé en ce que**
il est prévu un système de commande et d'analyse (12) avec une entrée de signaux de commande comprenant le système de diagnostique, au moyen duquel peuvent être générés des signaux de commutation correspondant à un signal de commande, et
qui présente un sortie de signaux de commutation (26) reliée avec l'entrée de signaux de commutation pour émettre des signaux de commutation numériques.

11. Procédé de diagnostique d'un circuit de courant de charge doté d'une source de courant ou de tension d'alimentation (14), d'un dispositif de commutation de charge (10) selon une des revendications 1 à 7 relié avec celle-ci et d'une charge (12) reliée avec le dispositif de commutation de charge (10) et la source de courant ou de tension d'alimentation (14),
dans lequel,
pour détecter un défaut de la charge (12) ou une liaison électrique défectueuse de la charge (12) au dispositif de commutation de charge (10), un signal de commutation est émis pour relier les connexions d'alimentation et de charge (20, 22), les connexions (20, 22) sont reliées entre elles et il est ensuite vérifié si la valeur d'une tension à la sortie de diagnostic (32) est inférieure à une valeur seuil inférieure prédéfinie, et/ou,
pour détecter un court-circuit entre la connexion de charge (22) et le pôle de la source de courant ou de tension d'alimentation (12) du dispositif de commutation de charge (10) relié directement avec la charge (10), un signal de commutation est émis pour relier les connexions d'alimentation et de charge (20, 22), les connexions (20, 22) sont reliées entre elles et il est vérifié si la valeur d'une tension à la sortie de diagnostic (32) est supérieure à une première valeur seuil supérieure prédéfinie, et,
pour détecter un court-circuit de la charge (12) par rapport au pôle de la source de courant ou de tension d'alimentation (14) relié directement avec la connexion d'alimentation (20), un signal de commutation est émis pour séparer les connexions d'alimentation et de charge (20, 22), une liaison entre les connexions d'alimentation et de charge (20, 22) est défaite et il est vérifié si la valeur d'une tension à la sortie de diagnostic est supérieure à une deuxième valeur seuil supérieure prédéfinie.
